# EUROPEAN PATENT APPLICATION

(11) **EP 4 592 883 A1**
(43) Date of publication of application: **30.07.2025**
(21) Application number: 25153943.3
(22) Date of filing: 24.01.2025
(51) Int. Cl.: G06F 30/00, G06F 30/13

(54) **BULK REPLICATION OF GUSSETS, PLATES AND END CAPS IN A STRUCTURE MODEL**

(30) Priority: 24.01.2024 US 202418420812
(71) Applicant: Dassault Systemes SolidWorks Corporation, Waltham, MA 02451-1223 (US)
(72) Inventor: Jodalli, Shravan, Waltham, 02451 (US); Amrutham, Nikhil, Waltham, 02451 (US); Apte, Makarand, Waltham, 02451 (US); Savant, Shrikant, Waltham, 02451 (US)
(74) Representative: Bandpay & Greuter

(57) **Abstract**

A computer aided drafting method suggests a structural member pair based on a selected supporting element for a modeled physical structure. A seed pair of a first seed structural member and a second seed structural member attached to the selected supporting element is designated. A feature vector is created for candidate structural members in the modeled physical structure. A first seed structural member feature vector is compared with a structural member feature vector to identify a first pair member candidate, and a second seed structural member feature vector is compared with the structural member feature vector, to identify a second pair member candidate for a candidate pair. A seed pair connector feature vector and a candidate pair connector feature vector is determined. The seed pair connector feature vector is compared with the candidate pair connector feature vector. The candidate pair is designated as a suggested pair, and the suggested pair is indicated in a displayed depiction of the modeled physical structure.

## Description

### FIELD OF THE INVENTION

The present invention relates to modeling of physical systems, and more particularly, is related to simplifying repetitive processes in a modeled system.

### BACKGROUND OF THE INVENTION

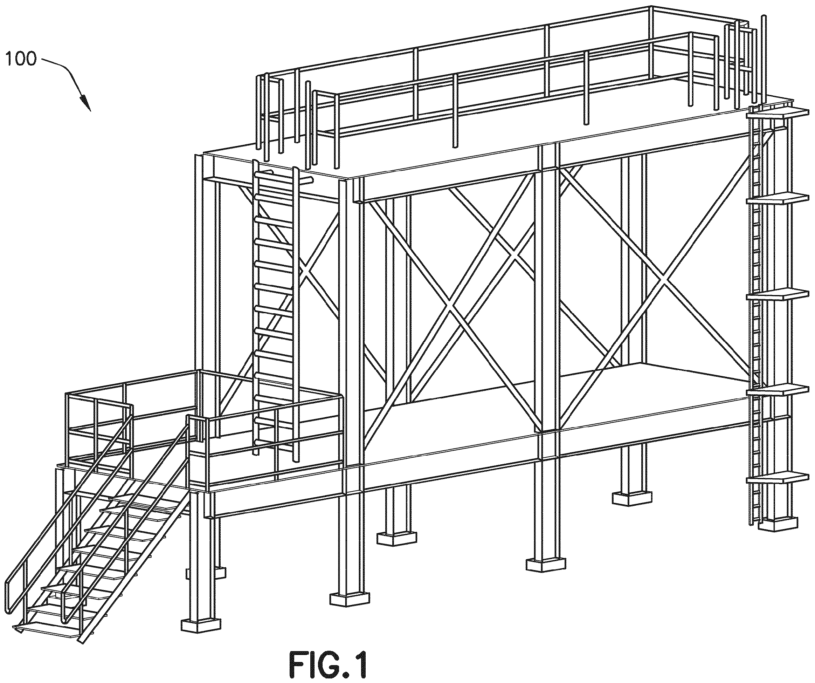

As shown by FIG. 1, a digital structure model 100 may represent a physical structure that is built to scale using materials such as wood, plastic, or metal. Physical models can be used to study the structural behavior of a building or bridge under different loads and conditions. The models may be created using specialized software, for example DS SOLIDWORKS and DS CATIA. CAD models can be used to visualize the structure and its components in three dimensions and to simulate its behavior under various loads and conditions.

When creating a computer aided drafting (CAD) model of a physical structure, the process of inserting, moving, orienting, and constraining a component can be quite repetitive and as such is subject to human error at every step of the process. Typically, methods of repetitively placing and constraining components, for example, gussets, plates, and end caps in a structural model, require the user to provide significant selections per command in modeling applications such as SOLIDWORKS. Similarly, a duplication command may be limited to geometries that exist on a shared surface (face) and/or have the same geometric properties. Variations in geometry may require the user to manually replicate the placement and constraint of another instance of the component before the gusset, plates, or end cap can be replicated through the aforementioned processes.

Once the user has manually defined a first gusset, plate, or end cap, replicating this gusset, plate, or end cap in other locations in the assembly causes the user to manually define every location and constraint or have the same geometry existing in each desired location. Such manual replication may be tedious since selection of each gusset, plate, or end cap may involve rotating and/or zooming the view of the model to allow the user to see and select the part, and such manipulation may be needed for every component selection. The identification of similar sized geometry on a given component can be quite difficult for the human eye often requiring the user to implement other means such as measurement tools or trial and error to determine if the selected geometry is appropriate. Therefore, there is a need in the industry to address one or more of the abovementioned shortcomings.

### SUMMARY OF THE INVENTION

Embodiments of the present invention provide a method for bulk replication of gussets, plates, and end caps in a structure model. Briefly described, the present invention is directed to a computer aided drafting method that suggests a structural member pair based on a selected supporting element for a modeled physical structure. A seed pair of a first seed structural member and a second seed structural member attached to the selected supporting element is designated. A feature vector is created for candidate structural members in the modeled physical structure. A first seed structural member feature vector is compared with a structural member feature vector to identify a first pair member candidate, and a second seed structural member feature vector is compared with the structural member feature vector, to identify a second pair member candidate for a candidate pair. A seed pair connector feature vector and a candidate pair connector feature vector is determined. The seed pair connector feature vector is compared with the candidate pair connector feature vector. The candidate pair is designated as a suggested pair, and the suggested pair is indicated in a displayed depiction of the modeled physical structure.

Other systems, methods and features of the present invention will be or become apparent to one having ordinary skill in the art upon examining the following drawings and detailed description. It is intended that all such additional systems, methods, and features be included in this description, be within the scope of the present invention and protected by the accompanying claims.

### BRIEF DESCRIPTION OF THE DRAWINGS

The accompanying drawings are included to provide a further understanding of the invention, and are incorporated in and constitute a part of this specification. The components in the drawings are not necessarily to scale, emphasis instead being placed upon clearly illustrating the principles of the present invention. The drawings illustrate embodiments of the invention and, together with the description, serve to explain the principles of the invention.
FIG. 1 schematic diagram of a rendering of an exemplary modeled structure having gussets, plates, and end caps.
FIG. 2A is a schematic diagram showing examples of base plates in a modeled structure.
FIG. 2B is a schematic diagram showing examples of gussets in a modeled structure.
FIG. 2C is a schematic diagram showing examples of end caps in a modeled structure.
FIG. 3 is a flowchart of an exemplary first embodiment method for suggesting a structural member based on a selected supporting element.
FIG. 4 is a flowchart that expands on the sub-processes for implementation of FIG. 3 block 400 for creating feature vectors for a structural member.
FIG. 5A is a flowchart that expands on the sub-processes for implementation of FIG. 3 block 500a for comparing a feature vector of the seed member with a feature vector of another structural member.
FIG. 5B is a flowchart that expands on the sub-processes for implementation of FIG. 3 block 500b for comparing a feature vector of the seed pair member with a feature vector of another structural member.
FIG. 6 is a flowchart of an exemplary second embodiment method for suggesting structural members based on a selected supporting element attached to two or more structural members.
FIG. 7 is a flowchart that expands on the sub-processes for implementation of FIG. 6 block 700 for creating connector feature vectors.
FIG. 8 is a flowchart 800 that expands on the sub-processes for implementation of FIG. 6 block 800 for comparing connector feature vectors.
FIG. 9 is a flowchart detailing how to create a connector vector between two members.
FIG. 10 is a schematic diagram illustrating an example of a system for executing functionality of the present invention.
FIG. 11A is a schematic diagram of a modeled structure with an end cap element selected on a pipe member.
FIG. 11B is a schematic diagram of the modeled structure of FIG. 11A showing end cap suggestions.
FIG. 11C is a schematic diagram of the modeled structure of FIG. 11A showing end caps added based on user acceptance of the suggestions.
FIG. 12A depicts a modeled structure As an example of a support element attached to two structural members.
FIG. 12B is a schematic diagram of the modeled structure of FIG. 12A showing suggestion locations.
FIG. 12C is a schematic diagram of the modeled structure of FIG. 12A showing structural members added based on user acceptance of the suggestions.

### DETAILED DESCRIPTION

The following definitions are useful for interpreting terms applied to features of the embodiments disclosed herein, and are meant only to define elements within the disclosure.

As used within this disclosure, a "structural member" refers to a component of a structure that receives (may be attached to) a supporting element. In a structural member, the pieces of metal that are welded together are typically large and heavy, often shaped into I-beams, H-beams, L-beams, pipes, or square beams. These types of beams provide strength and rigidity to the overall structure.

As used within this disclosure, a "seed member" refers to a structural member used as the basis of comparison with one or more "candidate members" of a modeled structure. Here, a candidate member refers to a structural member that is to be compared with a seed member. If a candidate member is sufficiently similar to the seed member (for example, according to a comparison criteria), the candidate member is thereafter identified as and referred to as a "suggested member," or a "suggestion."

As used within this disclosure, a "supporting element" refers to a gusset, a plate, an end cap, or another member attached to a structural member of an assembly.

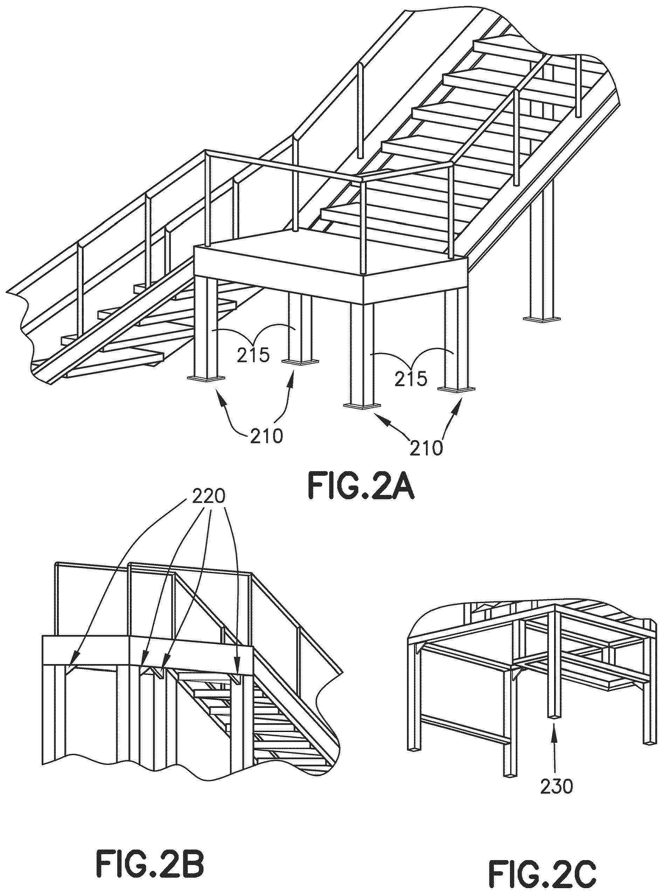

As used within this disclosure, "plate" refers to a first type of supporting element in an assembly. Plates are commonly used in structures to provide additional strength, stiffness, and support to various structural members 215 (FIG. 2A). Plates are typically flat, thin, and rectangular or circular-shaped pieces of material, such as steel or aluminum, which are often used in combination with beams, columns, and other types of structural members 215. Plates can be used in different ways in structural design. For example, plates may be used as base plates or stiffener plates. Base plates are used to distribute the weight of a column or other type of vertical structural member 215 over a larger area of the foundation, as shown by FIG. 2A. Base plates 210 are typically bolted or welded to the bottom of a column or other member. Stiffener plates may be used to provide additional stiffness and support to a structural member 215, such as a beam or column. Stiffener plates are typically welded or bolted to the member and help prevent buckling or twisting under heavy loads.

As used within this disclosure, "gusset" refers to a second type of supporting element in an assembly. As shown by FIG. 2B, gussets 220 are commonly used in conjunction with structural members to provide additional strength and support. Gussets 220 are typically small with respect to a respective supporting member 215, and may typically be triangular or rectangular pieces of material, such as metal or wood, which are added to a joint or connection point between two or more structural members 215. Gussets 220 are used to transfer loads and stresses between structural members 215 and to prevent buckling or twisting of the joint. They can also help distribute loads more evenly across the joint, which can reduce the risk of localized failure.

As used within this disclosure, "end cap" refers to a terminating structural member in an assembly, for example, a hollow structural member. FIG. 2C shows an exemplary end cap 230 . Examples of end caps include pipe end caps and furniture leg end caps. Pipe end caps are devices used to close off the ends of pipes. Pipe end caps may be made of various materials such as plastic, metal, or rubber and are often used to prevent dirt, debris, or water from entering the pipe. Furniture leg end caps may be small caps that can be placed on the ends of furniture legs to protect floors from scratches and to prevent furniture from sliding around. In general, end caps 230 can serve a variety of purposes, including protection, sealing, and aesthetic enhancement.

As used within this disclosure, a "descriptor" refers to a data structure describing the properties of a local region of geometry within the modeled assembly, in particular, properties of a member, a plate, a gusset, and an end cap, among others. A descriptor may include both text fields and numerical fields, as well as fields indicating relationships with other components and/or structural features. This usage of the term 'descriptor' is common in information retrieval systems. For example, in image retrieval system, descriptors contain the visual features of images such as shape, color or texture that help classify images. In a music search system, a descriptor may contain properties such as rhythm, scale, genre, artists etc. In a document retrieval system, a descriptor may contain the counts of individual words, author, language etc.

As used within this disclosure, a "component list" refers to a listing of individual parts of a two dimensional (2D) or three dimensional (3D) modeled assembly. In a CAD environment, a component list may be presented visually as a side-bar to a graphical window presenting a 2D or 3D rendering of the modeled assembly. The component list and the graphical window may be interactive, for example, selecting a component in the component list may highlight the corresponding component in the graphical window, and likewise selecting a component in the graphical window (for example, via a mouse click) may highlight the corresponding component in the component list.

As used within this disclosure, "model resolution" refers to a parameter of CAD system that indicates a minimum dimension, such that anything smaller than the model resolution is considered as zero length by the CAD system.

As used within this disclosure, a "face" refers to a surface of a part of a 2D or 3D modeled assembly.

As used within this disclosure, a "suggested structural member" (or "suggestion") refers to a structural member identified as a compatible pairing for a user selected supporting element.

As used within this disclosure, "one-hot encoding" refers to a technique used in machine learning and data preprocessing to represent categorical variables as binary vectors. For example, hot-one encoding may be beneficial when working with algorithms that require numerical input, such as neural networks and many machine learning models.

Reference will now be made in detail to embodiments of the present invention, examples of which are illustrated in the accompanying drawings. Wherever possible, the same reference numbers are used in the drawings and the description to refer to the same or like parts.

Plates, gussets, and end caps are commonly used to add support or strength in any structural model design. The exemplary embodiments described here reduce the repetitive selection of similar member properties, member lengths, and corner joints in the component to add the plates, gussets, and end caps. The exemplary embodiments also greatly reduce stress and human errors as structure models are usually large and usually involve multiple selections that require rotating/ zooming the model.

The exemplary embodiments provide for bulk replication of multiple gussets, plates, or end caps with minimal user input. In an exemplary workflow. The user selects one or more structural elements (like gussets, plates, end caps) of interest to be replicated in a structural model via the user interface of a CAD environment.

The embodiments analyze each structural element of interest, for example, placement of the structural element and one or more properties of a parent structural member (or a set of parent structural members) the structural element supports. The embodiments scan data structures of the structure model to search for other structural members (or other sets of structural members) with similar properties and geometric configurations to the parent element(s). If one or more similar structural members are found, the embodiments presents a preview to the user suggesting new structural elements like the selected structural element that can be replicated for the similar structural members.

The embodiments give the user an opportunity to select additional structural elements to be replicated using the same process as previously described. The user can then choose to automatically apply all the suggested replications or exclude specified suggestions and replicate the rest of the suggestions. The embodiments allow the user to specify variations of one or more parameters of the selected structural element to adjust scope of the structural member search.

The embodiments may be implemented as an application or feature within a CAD environment, effectively automating portions of an otherwise tedious manual process, and improving overall ergonomics of the CAD system.

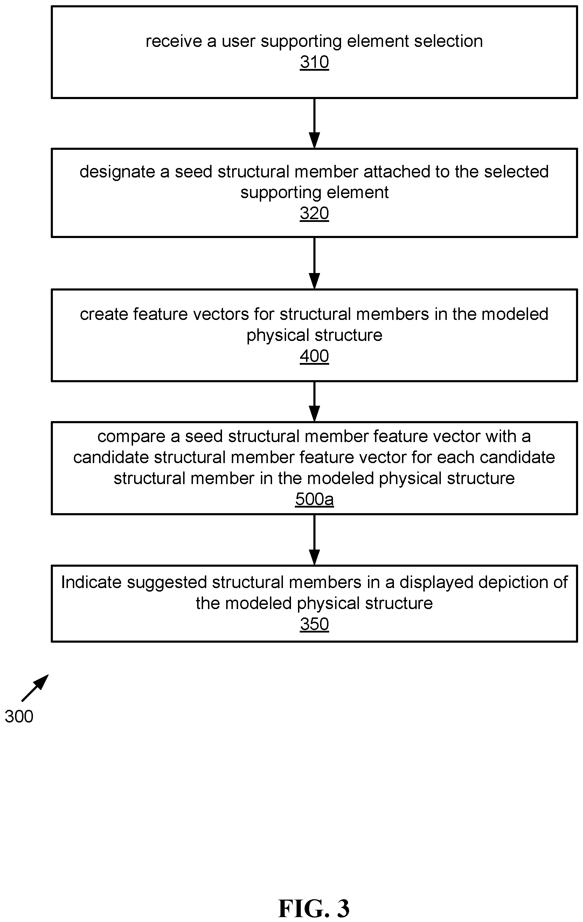

FIG. 3 is a flowchart of an exemplary first embodiment method for finding a suggested structural member based on a selected supporting element. It should be noted that any process descriptions or blocks in flowcharts should be understood as representing modules, segments, portions of code, or steps that include one or more instructions for implementing specific logical functions in the process, and alternative implementations are included within the scope of the present invention in which functions may be executed out of order from that shown or discussed, including substantially concurrently or in reverse order, depending on the functionality involved, as would be understood by those reasonably skilled in the art of the present invention.

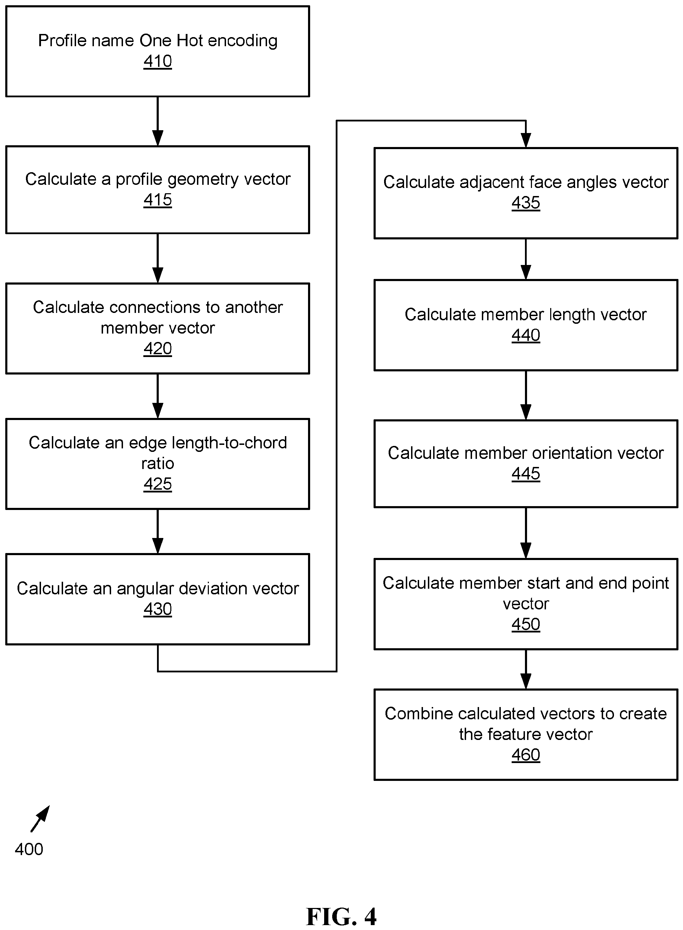

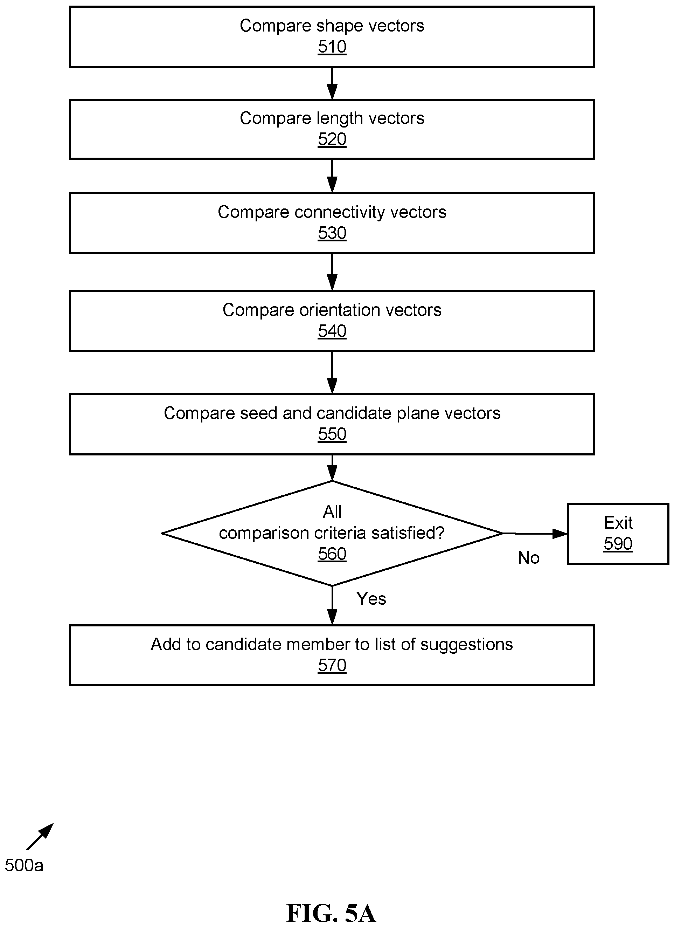

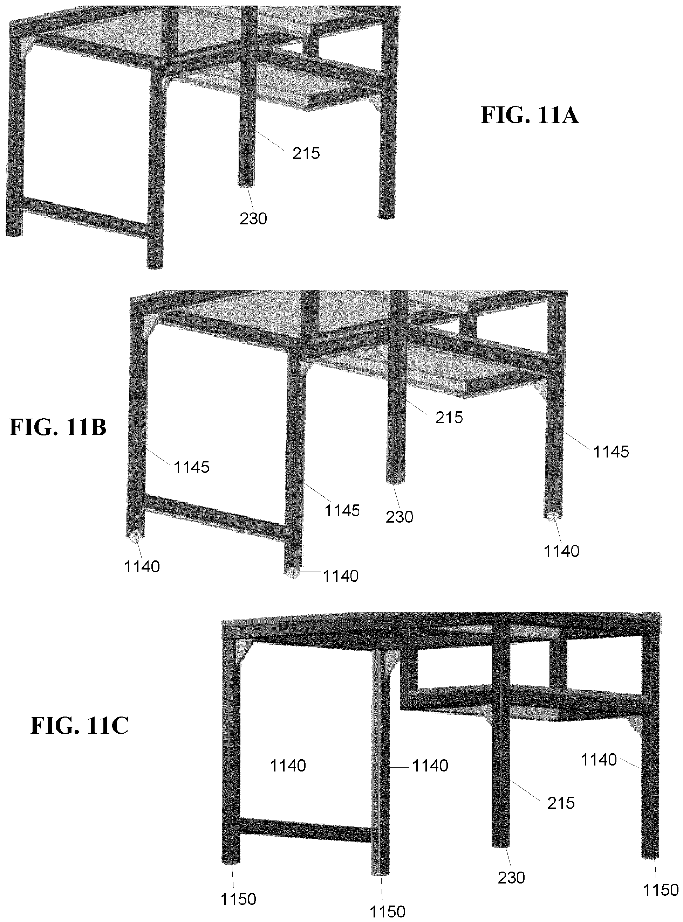

A user selection of the selected supporting element is received, as shown by block 310. For example, the selected supporting element may be a plate, a gusset, or an end cap. FIG. 11A depicts a modeled structure with a selected end cap element 230 attached to a structural member (rectangular tube) 215. A structural member attached to the selected supporting element is designated as a seed structural member ("seed member"), as shown by block 320. For the example of FIG. 11A, the rectangular tube 215 is the designated seed member.
A feature vector is created for each of a plurality structural members in the modeled physical structure, as shown by block 400. Creation of the feature vector is described below with regard to FIG. 4. A seed structural member feature vector is compared with a structural member feature vector (a "suggestion candidate," or "candidate member") of the plurality of structural members in the modeled physical structure, as shown by block 500a. Comparison of the feature vector is described below with regard to FIG. 5A. The user may adjust one or more options regarding the seed structural member feature vector to relax or tighten the comparison criteria. The comparison of block 550a yields one or more suggested structural member ("suggestion"). As noted previously, a suggested structural member refers to a structural member identified as a compatible pairing for the selected supporting element. Here, at least one feature of the suggested structural member matches a corresponding feature of the seed structural member, so the suggestion candidate is designated as a suggestion. FIG. 11B shows suggested pipes 1145 and associated end cap suggestions 1140.

The suggested structural member is indicated in a displayed depiction of the modeled physical structure, as shown by block 350. The suggested structural member may be indicated, for example, by colored highlighting. Alternatively, the suggested structural member may be indicated in a list of candidate structural members. The user may accept the suggested structural member, for example, by selecting the structural member indicated in the display. Upon user selection of the suggested structural member the CAD system duplicates the selected supporting structural element at the suggested structural member ("suggestion"). FIG. 11C shows end caps 1150 added based on user acceptance of the suggestions.

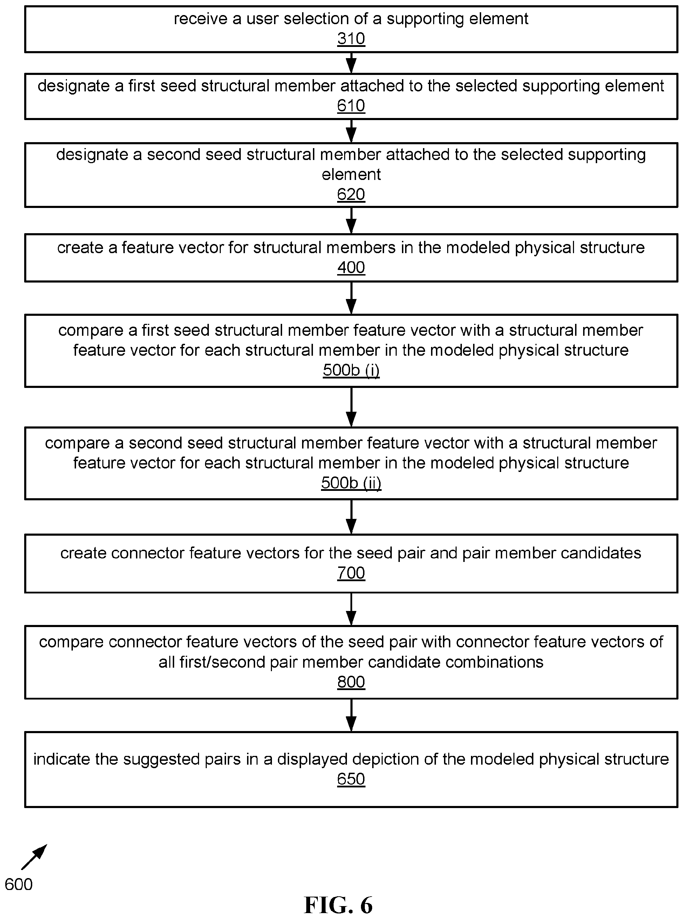

If more than one structural member is attached to the selected supporting element, each such member is considered a seed member. Here, connector feature vectors are created for the seed members and the suggested members. This is described further below regarding a second exemplary embodiment with respect to FIGS. 6-9.

FIG. 4 expands on the sub-processes for implementation of FIG. 3 block 400. Regarding block 410, "Profile name One Hot Encoding," the embodiments employ multiple standards for the profiles of structural members. Each profile may be denoted by a unique name such as 'ST,' 'C,' 'FL,' 'L,' 'M,' 'MC,' 'MT,' 'PIPE,' 'Round HSS,' 'S,' 'W,' 'WT,' 'WRF,' 'WWF,' 'WWT,' 'HA,' 'HS,' 'L,' 'M,' 'MC,' 'Round HA,' 'Round HS,' 'W,' 'WRF,' 'WWF,' 'WWT,' 'L,' 'PFC,' 'FlatBar,' 'HD,' 'HE,' 'HL,' 'HLZ,' 'HP,' 'I,' 'IPE,' 'IPN,' 'J,' 'L,' and 'PFC,' where each corresponding profile is characterized by a distinct shape. For instance, the 'C' profile may encompass a range of sizes, for example, including ['6X8.2', '6X10.5', '3X3.5', '3X4.1', '3X5', '3X6', '4X4.5', '4X5.4', '4X6.25', '4X7.25', '5X6.7', '5X9', '6X8.2', '6X10.5'], where in this example the unit of measure is in inches.

Feature vectors are created from these profile names using a one-hot encoding technique. Each profile name corresponds to a unique feature within the vector. A '1' indicates the presence of the specific profile, while '0' signifies its absence, enabling effective representation and analysis of the structural profiles used in the CAD models. For instance, when applied to a model using three profiles:
- For 'L 20 x 20' profile, its vector is [1,0,0]
- For 'L 30 X 30' profile, its vector is [0,1,0]
- For 'Square 20 X 20' profile, its vector is [0,0,1]

A profile geometry vector is calculated, as shown by block 415. Essential characteristics of a cross-sectional shape of the member are extracted from the member descriptor (data structure), such as its area, edge lengths, and angles between edges. The following is an example of how to incorporate geometric properties of an element as a feature vector, here, for a square profile with sides measuring 20 mm. The feature vector can be written as:
- Area: 400mm2
- Edge Lengths: [20, 20, 20, 20]
- Angles Between Edges: [90, 90, 90, 90]
and the resultant feature vector is: [400, 20, 20, 20, 20, 90, 90, 90, 90].

Connections to vectors of other members are calculated, as shown by block 420, for example, connections a member forms with other members at their respective ends. These connections or associations are tallied and included in the member descriptor. The resulting count of these connections is utilized in the descriptor. For example, if a specific member is attached to four other members, its feature vector would be represented as [4]. This vector captures the connectivity information, which may be used for further structural analysis.

An edge length-to-chord ratio is calculated, as shown by block 425. The ratio of the edge length of a member to its chord length is a reliable feature that effectively conveys the member shape. The chord length represents the straight-line distance between the member's initial and final points. For example, if an arc has a length of 20 mm and the distance between its start and end points is 10 mm, the feature vector is represented as [2]. This vector succinctly characterizes the shape of the member by highlighting the elongation or curvature in the path it follows.

An angular deviation vector is calculated, as shown by block 430. Here, angular deviation refers to the angle between the initial and final orientations of a structural member. The angular deviation vector quantifies the angular change along the member's length, providing important information for structural analysis. For example, if a member exhibits a 45-degree angular difference between a tangent at its starting point and a tangent at its endpoint, the feature vector is expressed as [45].

An adjacent face angles vector is calculated, as shown by block 435. Adjacent face angles refer to the angles between the two faces that neighbor an edge shared by adjacent members. The adjacent face angles attribute offers valuable insights into how adjacent members are interconnected. The adjacent face angles feature vector succinctly captures the relationship and connectivity between the adjacent members, which is important for understanding and analyzing the structural configuration. For example, if a specific member is attached to two other members with angles of 45 and 90 degrees, the feature vector representing these adjacent face angles would be [90, 90].

A member length vector is calculated, as shown by block 440. The length of a structural member is determined by measuring the distance along its curved path, spanning from the starting point to the endpoint. The member length feature vector succinctly describes the extent of the member along its curve, facilitating structural analysis and design considerations. For example, if a member has a length of 5000 mm, this characteristic can be represented by the feature vector [5000].

A member orientation vector is calculated, as shown by block 445. Here, the orientation of a structural member is quantified by calculating the tangents at its initial and terminal points. For example, If the tangent at the starting point is (1, 0, 0) and the tangent at the endpoint is (-1, 0, 0), the feature vector to describe this orientation is defined as [1, 0, 0, -1, 0, 0].

For optional settings related to a plane of a suggestion for filtering structural members, the start and end points of the member are essential criteria. The following provides more detail for block 450. Here, the embodiments calculate a vector for the suggestion start and end point.

The specific conditions for filtering based on the supporting element type are as follows. For a plate, either the suggestion start point or the suggestion end point needs to lie on the plane of a suggested structural member. For a gusset, the distance from both the starting point and the end point to the plane should be the same. This distance should be less than or equal to the width of the cross-section of the suggested structural member.

The start/end point feature vector helps identify and classify members based on their proximity to the specified plane, enabling accurate filtering in the analysis process. For example, given a structural member with the start point at (10, 0, 0) and the end point at (100, 0, 0), the corresponding feature vector for filtering these conditions is represented as [10, 0, 0, 100, 0, 0].

For any given member, various attributes are combined to create feature vectors for comparison. The following is a breakdown of the combined exemplary feature vectors:
- Edge to Chord Ratio, Angular Deviation, and Profile Name or Profile Geometry:
   Feature Vector: [2, 45, 1, 0, 0] or [2, 45, 400, 20, 20, 20, 20, 90, 90, 90, 90].
- Number of Connections to Others and Adjacent Face Angles:
   Feature Vector: [4, 90, 90].
- Length:
   Feature Vector: [5000].
- Orientation:
   Feature Vector: [1, 0, 0, -1, 0, 0].
- End Points:
   Feature Vector: [10, 0, 0, 100, 0, 0].
These feature vectors efficiently encapsulate specific member attributes, making it possible to conduct thorough comparisons, analysis, and the identification of unique characteristics among different members. Additionally, the embodiments may provide users the ability to enable or disable certain parameters, such as length, orientation, and end points, to suit their specific comparison needs. Under a first exemplary embodiment, user options for structural member analysis include several attributes with default settings:
- Length (Enabled by default)
- Orientation (Disabled by default)
- Plane of Suggestions (Disabled by default)
- Connectivity to Others (Enabled by default)
Here, by default, Length and Connectivity to Others are active features. Users have the flexibility to enable or disable Orientation and Plane of Suggestions based on their specific needs.

In an alternative embodiment, the user may choose to activate a "plane of suggestions" option to select a plane within the model. Once selected, only suggestions that pertain to members lying on the chosen plane of suggestions are presented to the user. This feature enhances user control and customization during the analysis process.

FIG. 5A is a flowchart that expands on the sub-processes for implementation of FIG. 3 block 500a for comparing a feature vector of the seed member with a feature vector of the candidate member. Each of the blocks 510, 520, 530, 540, and 550 involve a comparison of feature vectors of a candidate member with feature vectors of the seed member.

One or more shape vector of the seed member is compared with one or more corresponding shape vector of the candidate member, as shown by block 510. Here, for example, the embodiments may compare one or more of the combined vector of edge to chord ratio, angular deviation, profile name and/or profile geometry of the seed member with the combined vector of the candidate member under evaluation. This comparison may involve calculating the L2 norm between the feature vectors, for example, setting a threshold of 0.1 for this evaluation.

One or more length vector of the seed member is compared with one or more corresponding length vector of the candidate member, as shown by block 520. This comparison entails utilizing the absolute difference for assessment, and the threshold for comparison may be determined by a specified tolerance of the model.

One or more connectivity vector of the seed member is compared with one or more corresponding connectivity vector of the candidate member, as shown by block 530. Here, for example, the embodiments may compare the combined vector of number of connections to others and adjacent face angles of the seed member with the combined vector of the candidate member under evaluation. This comparison may involve calculating the L2 norm between the feature vectors, for example, setting a threshold of 0.1 for this evaluation.

One or more orientation vector of the seed member is compared with one or more corresponding orientation vector of the candidate member, as shown by block 540. Here, for example, the embodiments may compare the Orientation vector of the seed member with the Orientation vector of the candidate member under evaluation. This comparison may involve calculating the L2 norm between the feature vectors, for example, setting a threshold of 0.1 for this evaluation.

One or more plane vector of the seed member is compared with one or more corresponding plane vector of the candidate member, as shown by block 550. Here, for example, in the presence of a plane of suggestions the embodiments may extract the start and end points from the end points feature vector. Subsequently, the embodiments check whether either of these points coincides with the user-specified plane.

A determination is made of whether the comparison criteria of each preceding block has been satisfied, as shown by block 560. For all the comparisons, the outcome is determined as follows:
- If a member fits the criteria, the result is true.
- If an attribute is optional and not calculated, the result is also considered true.
- If a member fails to meet the criteria, the result is false.
If not all of the criteria are determined to be true, the comparison exits without advancing the candidate member to be a suggestion, as shown by block 590. If all of the criteria are determined to be true, the candidate member is added to a list of suggestions, as shown by block 570.

It should be noted that different implementations of the embodiments may omit one or more of the comparison blocks 510, 520, 530, 540, and 550, and/or the user of the CAD environment may select which of the comparison blocks 510, 520, 530, 540, and 550 to include. In alternative embodiments, the criteria check of block 560 may be performed after any one or more of blocks 510, 520, 530, 540, and 550.

FIG. 6 is a flowchart of an exemplary second embodiment method for suggesting structural member pairs ("suggestion pairs") based on a selected supporting element attached to two or more structural members.

A selection of the selected supporting element is received, as shown by block 310. For example, the CAD system user may select a supporting element, such as a gusset, from a displayed depiction of a structure. The two or more supporting structural members attached to the selected supporting element are termed "seed members." For exemplary purposes, the following description is directed to a selected supporting element attached to a first seed structural member, designated as a first seed structural member, as shown by block 610, and a second seed structural member, designated as a second seed structural member as shown by block 620. Collectively, the first seed member and the second seed member form a seed member pair, or "seed pair" for short.

Suggestion element pairs ("suggestion pairs") are identified based on the comparing the seed pair with pairs of candidate structural elements. For a candidate pair to be deemed a suggestion pair, a first pair member candidate matches a corresponding feature of the first seed member, a second pair member candidate matches a corresponding feature of the second seed member, and a seed pair connector feature vector matches a corresponding candidate pair connector feature vector.

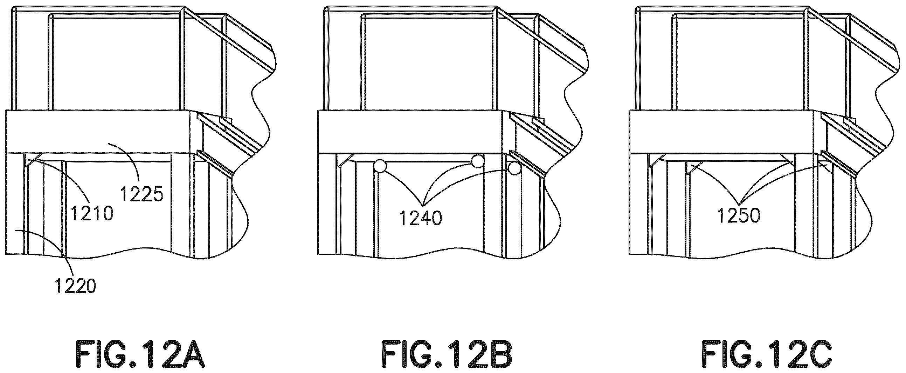

As an example of a support element attached to two structural members, FIG. 12A depicts a modeled structure with a selected gusset element 1250 attached to a first structural member 1220 and a second structural member 1225. The first structural member 1220 is designated as a first seed structural member ("seed member"), as shown by block 610. The second structural member 1225 is designated as a second seed member, as shown by block 620.

A feature vector is created for each of the plurality structural members in the modeled physical structure, as shown by block 400. Creation of feature vectors was described previously with regard to FIG. 4.

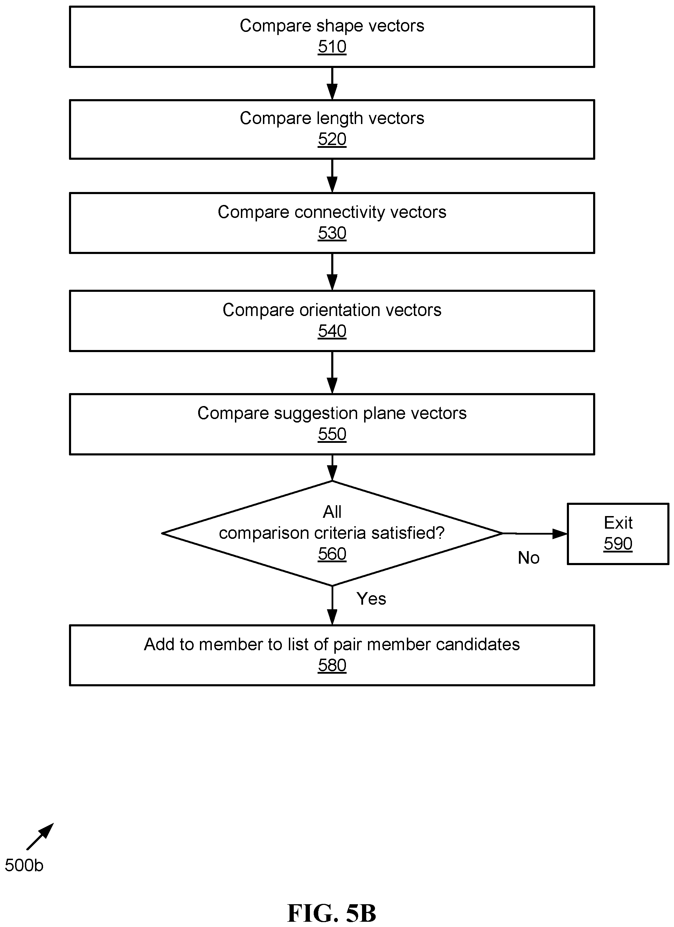

A first seed structural member feature vector is compared with a structural member feature vector, as shown by block 500b (i). Comparison of feature vectors was described above with regard to FIG. 5B. A successful comparison results in deeming the matched structural member as a first pair member candidate, which is added to a list of first pair member candidates. This process iterates until all structural members in the structure have been checked for being first pair member candidates.

A second seed structural member feature vector is compared with a structural member feature vector of the plurality of structural members in the modeled physical structure, as shown by 500b (ii). Comparison of feature vectors was described above with regard to FIG. 5B. A successful comparison results in indicating a second pair member candidate which is added to a list of second pair member candidates. This process iterates until all structural members in the structure have been checked for being second pair member candidates.

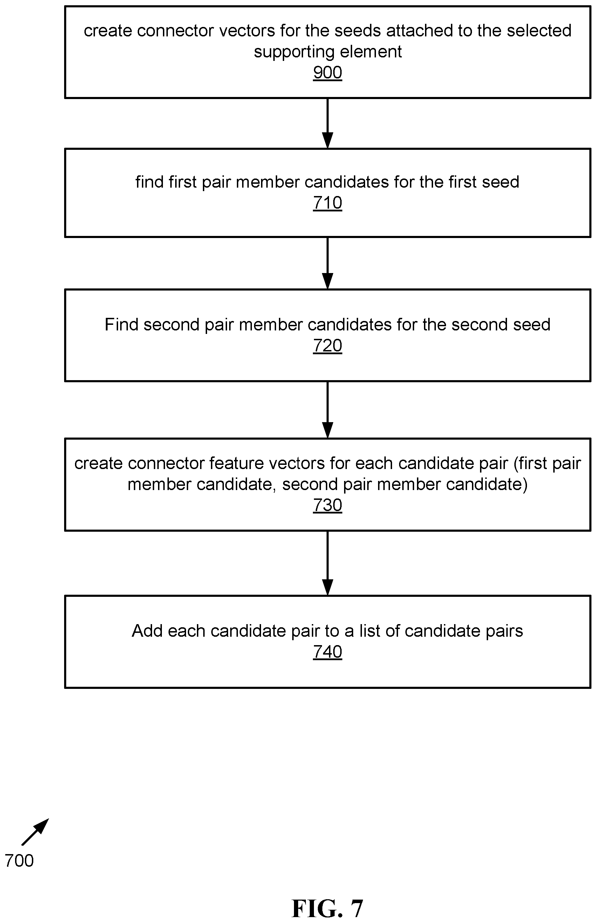

Connector feature vectors are created for the seed pair and for each pairing of first/second pair member candidates, as shown by block 700. Block 700 is expanded in FIG. 7, as described further below. Here, a list of candidate pairs of structural elements is produced. A candidate pair is not deemed to be a suggestion until a connector feature vector for the first/second pair member candidates has been favorably compared with a seed pair connector feature vector.

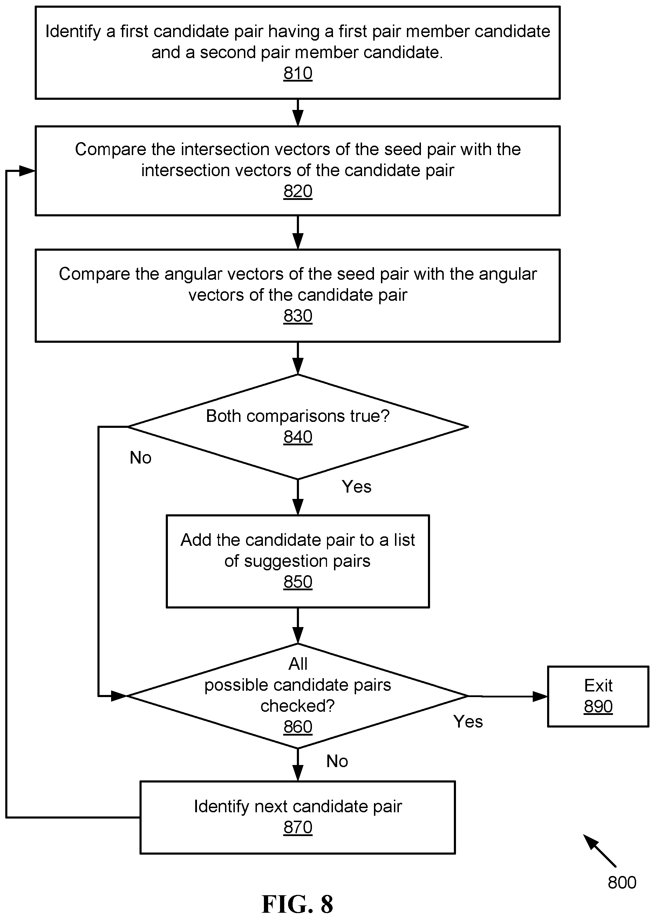

Connector feature vectors of the seed pair are compared with connector feature vectors of all first/second pair member candidates, as shown by block 800. Block 800 is expanded in FIG. 8, as described further below. This results in a list of suggested structural member pairs. FIG. 12B shows suggested gusset locations 1240 displayed with respect to suggested structural pairs.

Suggested structural member pairs in the list of suggested structural member pairs are indicated in a displayed depiction of the modeled physical structure, as shown by block 650. The suggested pairs may be indicated, for example, by colored highlighting. The user may accept a suggested pair, for example, by selecting the structural pair indicated in the display. Upon user selection the CAD system duplicates the selected supporting element at the suggested pair. FIG. 12C shows gussets 1250 added based on user acceptance of the suggestions.

When there are two seed members, they may be referred to as a seed pair. Similarly, two candidate members may be referred to as a candidate pair, and two corresponding suggested members may be referred to as a suggested pair. The above description of FIG. 6 describes seed pairs and candidate/suggestion pairs. However, the method 600 may be extended to three, four, or more seed members and corresponding candidate/suggestion members, which may be referred to as seed groups and candidate/suggestion groups, where connector feature vectors are created and compared for each member of seed group or candidate/suggestion group.

A connector vector describes the relationship between two paired structural members. The connector vector incorporates an intersection vector and an angular vector. An intersection vector for the seed pair is calculated for the seed pair first member and the seed pair second member. An angular vector for the seed pair is calculated for the seed pair first member and the seed pair second member. An intersection vector for the candidate pair is calculated for the first pair member candidate member and the second pair member candidate. An angular vector for the candidate pair is calculated for the first pair member candidate member and the second pair member candidate.

FIG. 5B is a flowchart that expands on the sub-process for implementation of FIG. 3 block 500b for comparing a feature vector of the seed pair member with a feature vector of another structural member. Each of the blocks 510, 520, 530, 540, and 550 involve a comparison of feature vectors of the structural member with feature vectors of the seed member. The description of blocks 510, 520, 530, 540, and 550 is provided above regarding the description of FIG. 5A.

A determination is made of whether the comparison criteria of each preceding block has been satisfied, as shown by block 560. For all the comparisons, the outcome is determined as follows:
- If a member fits the criteria, the result is true.
- If an attribute is optional and not calculated, the result is also considered true.
- If a member fails to meet the criteria, the result is false.
If not all of the criteria are determined to be true, the comparison exits without advancing the candidate member to be a suggestion, as shown by block 590. If all of the criteria are determined to be true, the candidate member is added to a list of pair member candidates, as shown by block 580.

It should be noted that different implementations of the embodiments may omit one or more of the comparison blocks 510, 520, 530, 540, and 550, and/or the user of the CAD environment may select which of the comparison blocks 510, 520, 530, 540, and 550 to include. In alternative embodiments, the criteria check of block 560 may be performed after any one or more of blocks 510, 520, 530, 540, and 550.

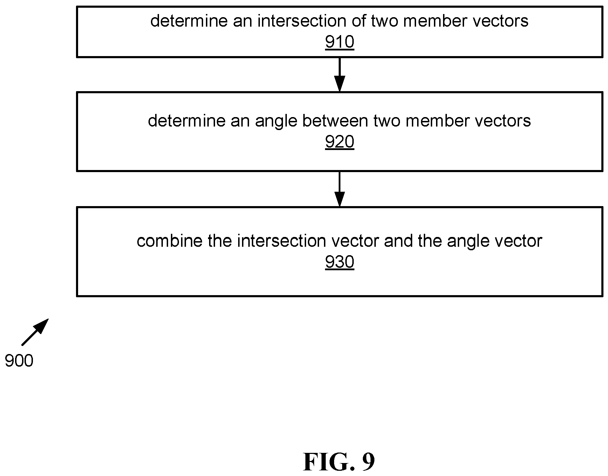

FIG. 7 is a flowchart 700 that expands on the sub-process for implementation of FIG. 6 block 700 for creating connector feature vectors for the seed pair and candidates. Connector vectors are created for the seeds attached to the selected supporting element (plate or gusset), as shown by block 900. The process for creating a connector vector is described below regarding FIG. 9. First pair member candidates are found for the first seed, as shown by block 710. Second pair member candidates are found for the second seed, as shown by block 720. Here, the first and second pair member candidates are found in a similar manner to identifying single suggestions as per the first embodiment (FIG. 3). Connector vectors are created for a candidate pair (where a candidate pair consists of a first pair member candidate paired with a second pair member candidate) as shown by block 730. Here, each member pair first pair member candidate has been favorably matched with the seed pair first seed member, and each member pair second pair member candidate has been favorably matched with the seed pair second seed member.

Each candidate pair is added to a list of candidate pairs for later comparison with a seed pair, described further regarding FIG. 8. This is to determine whether the relationship between the candidate pair members matches the relationship between the seed pair members.

FIG. 9 is a flowchart detailing how to create a connector vector between two members. The intersection of two member vectors is determined, as shown by block 910. When two members fail to meet a comparison criteria, the resulting vector may be, for example, [-1, -1]. However, if the two members do intersect at a specific point, the embodiments calculate the ratio of the distance from the point of intersection to one end over the total distance between the end points for each member. This vector conveys the relative positioning of the intersecting point along the length of each member. For instance, if the intersection point on the first member is situated at a ratio of 0.3 from one end, and on the other member, it is at a ratio of 0.4, the vector is represented as [0.3, 0.4].

An angle between two member vectors is determined, as shown by block 920. The angle is based on the tangents of the respective member orientation vector at the start point of the two members. The first tangent is for the seed or candidate and the second tangent is for a neighbor attached to seed or candidate. Between these members we have an intersection point. The first tangent is evaluated on the seed or candidate at the intersection point between the first and second members. The second tangent is evaluated on the neighbor at the intersection point. The angle attribute offers insights into how the two members are oriented with respect to each other. The resulting angle feature vector succinctly captures the relationship and connectivity between the two members. For example, if a specific member is attached to the other member with an angle of 90 degrees, the feature vector representing these adjacent face angles would be [90]. The intersection vector and the angle vector are combined to form the connector vector, as shown by block 930.

FIG. 8 is a flowchart 800 that expands on the sub-processes for implementation of FIG. 6 block 800 for comparing connector feature vectors. A first candidate pair having a first pair member candidate and a second pair member candidate is identified, as show by block 810. The intersection vectors of the seed pair is compared with the intersection vectors of the candidate pair, as shown by block 820. For example, in the context of intersection vectors, where the seed intersection vector is [0.3, 0] and the candidate pair intersection vector is [0.7, 0], the interpretation is as follows:
For the seed:
   - On the first seed member, the intersection point divides the member length into a ratio of 0.3 to 0.7 of the total length.
   - On the second seed member, the intersection point meets at one of the ends.
For the candidate:
   - On the first candidate member, the intersection point divides the member length into a ratio of 0.7 to 0.3 of the total length.
   - On the second candidate member, the intersection point meets at one of the ends.

The L2 norm is calculated between these intersection vectors, considering all possible permutations to account for any distinctions between start and end points. For the above values, the second embodiment calculates ([0.3, 0] and [0.7, 0]), ([1 - 0.3, 1 - 0] and [0.7, 0]), ([0, 0.3] and [0.7, 0]) and ([1 - 0, 1 - 0.3] and [0.7, 0]). If any of the combination return an IL2 norm less than 0.1, the comparison returns true.

The angular vectors of the seed pair is compared with the angular vectors of the candidate pair, as shown by block 830. If both the intersection and angular vector comparisons are true, as per block 840, the candidate pair is added to a list of suggestion pairs. The second embodiment calculates the L2 norm between angles and if the L2 norm is less than 0.1, returns true for the comparison.

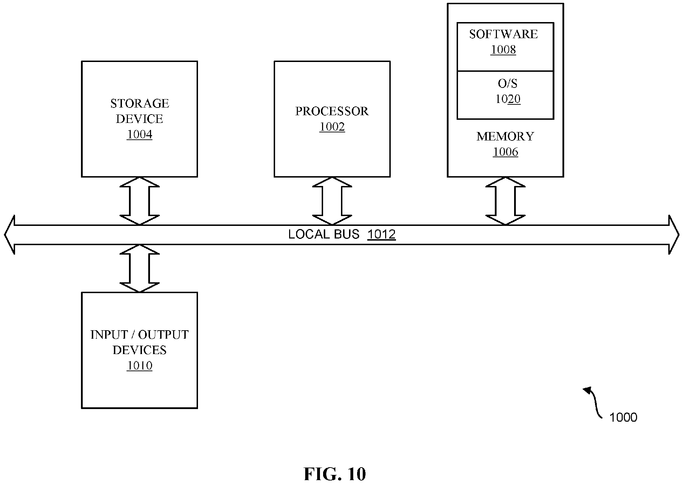

The present system for executing the functionality described in detail above may be a computer, an example of which is shown in the schematic diagram of FIG. 10. The system 1000 contains a processor 1002, a storage device 1004, a memory 1006 having software 1008 stored therein that defines the abovementioned functionality, input, and output (I/O) devices 1010 (or peripherals), and a local bus, or local interface 1012 allowing for communication within the system 1000. The local interface 1012 can be, for example but not limited to, one or more buses or other wired or wireless connections, as is known in the art. The local interface 1012 may have additional elements, which are omitted for simplicity, such as controllers, buffers (caches), drivers, repeaters, and receivers, to enable communications. Further, the local interface 1012 may include address, control, and/or data connections to enable appropriate communications among the aforementioned components.

The processor 1002 is a hardware device for executing software, particularly that stored in the memory 1006. The processor 1002 can be any custom made or commercially available single core or multi-core processor, a central processing unit (CPU), an auxiliary processor among several processors associated with the present system 1000, a semiconductor based microprocessor (in the form of a microchip or chip set), a macroprocessor, or generally any device for executing software instructions.

The memory 1006 can include any one or combination of volatile memory elements (e.g., random access memory (RAM, such as DRAM, SRAM, SDRAM, *etc*.)) and nonvolatile memory elements (*e.g.,* ROM, hard drive, tape, CDROM, *etc*.). Moreover, the memory 1006 may incorporate electronic, magnetic, optical, and/or other types of storage media. Note that the memory 1006 can have a distributed architecture, where various components are situated remotely from one another, but can be accessed by the processor 1002.

The software 1008 defines functionality performed by the system 1000, in accordance with the present invention. The software 1008 in the memory 1006 may include one or more separate programs, each of which contains an ordered listing of executable instructions for implementing logical functions of the system 1000, as described below. The memory 1006 may contain an operating system (O/S) 1020. The operating system essentially controls the execution of programs within the system 1000 and provides scheduling, input-output control, file and data management, memory management, and communication control and related services.

The I/O devices 1010 may include input devices, for example but not limited to, a keyboard, mouse, scanner, microphone, *etc.* Furthermore, the I/O devices 1010 may also include output devices, for example but not limited to, a printer, display, *etc.* Finally, the I/O devices 1010 may further include devices that communicate via both inputs and outputs, for instance but not limited to, a modulator/demodulator (modem; for accessing another device, system, or network), a radio frequency (RF) or other transceiver, a telephonic interface, a bridge, a router, or other device.

When the system 1000 is in operation, the processor 1002 is configured to execute the software 1008 stored within the memory 1006, to communicate data to and from the memory 1006, and to generally control operations of the system 1000 pursuant to the software 1008, as explained above.

When the functionality of the system 1000 is in operation, the processor 1002 is configured to execute the software 1008 stored within the memory 1006, to communicate data to and from the memory 1006, and to generally control operations of the system 1000 pursuant to the software 1008. The operating system 1020 is read by the processor 1002, perhaps buffered within the processor 1002, and then executed.

When the system 1000 is implemented in software 1008, it should be noted that instructions for implementing the system 1000 can be stored on any computer-readable medium for use by or in connection with any computer-related device, system, or method. Such a computer-readable medium may, in some embodiments, correspond to either or both the memory 1006 or the storage device 1004. In the context of this document, a computer-readable medium is an electronic, magnetic, optical, or other physical device or means that can contain or store a computer program for use by or in connection with a computer-related device, system, or method. Instructions for implementing the system can be embodied in any computer-readable medium for use by or in connection with the processor or other such instruction execution system, apparatus, or device. Although the processor 1002 has been mentioned by way of example, such instruction execution system, apparatus, or device may, in some embodiments, be any computer-based system, processor-containing system, or other system that can fetch the instructions from the instruction execution system, apparatus, or device and execute the instructions. In the context of this document, a "computer-readable medium" can be any means that can store, communicate, propagate, or transport the program for use by or in connection with the processor or other such instruction execution system, apparatus, or device.

Such a computer-readable medium can be, for example but not limited to, an electronic, magnetic, optical, electromagnetic, infrared, or semiconductor system, apparatus, device, or propagation medium. More specific examples (a nonexhaustive list) of the computer-readable medium would include the following: an electrical connection (electronic) having one or more wires, a portable computer diskette (magnetic), a random access memory (RAM) (electronic), a read-only memory (ROM) (electronic), an erasable programmable read-only memory (EPROM, EEPROM, or Flash memory) (electronic), an optical fiber (optical), and a portable compact disc read-only memory (CDROM) (optical). Note that the computer-readable medium could even be paper or another suitable medium upon which the program is printed, as the program can be electronically captured, via for instance optical scanning of the paper or other medium, then compiled, interpreted, or otherwise processed in a suitable manner if necessary, and then stored in a computer memory.

In an alternative embodiment, where the system 1000 is implemented in hardware, the system 1000 can be implemented with any or a combination of the following technologies, which are each well known in the art: a discrete logic circuit(s) having logic gates for implementing logic functions upon data signals, an application specific integrated circuit (ASIC) having appropriate combinational logic gates, a programmable gate array(s) (PGA), a field programmable gate array (FPGA), etc.

The embodiments may be used in an automated manufacturing process for a physical structure based on the modeled structure. For example, the supporting elements identified and created by the embodiments may be added to inventory lists for either ordering or automated manufacturing of the suggested supporting elements added to the model during execution of the embodiment methods. Likewise, the resulting information regarding the orientation of the suggested supporting elements may be used to control manufacturing machinery used to produce assemblies and/or subassemblies of the actual physical structure.

Further by reducing the manual repetition involved in replicating supporting elements improves the ergonomics of the CAD environment, for example, reducing repetitive stress injuries in operating the input/output devices, as well as reducing possible errors in repeated manual operations.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A computer based method for suggesting a structural member pair based on a selected supporting element for a modeled physical structure in a computer aided drafting (CAD) environment, comprising the steps of:
receiving a selection of the selected supporting element;
designating a seed pair comprising a first seed structural member attached to the selected supporting element, and a second seed structural member attached to the selected supporting element;
creating a feature vector for each of a plurality of candidate structural members in the modeled physical structure;
comparing a first seed structural member feature vector with a structural member feature vector, each of the plurality of candidate structural members in the modeled physical structure to identify a first pair member candidate;
comparing a second seed structural member feature vector with the structural member feature vector, each of the plurality of candidate structural members in the modeled physical structure to identify a second pair member candidate for a candidate pair comprising the first pair member candidate and the second pair member candidate;
determining a seed pair connector feature vector and a candidate pair connector feature vector;
comparing the seed pair connector feature vector with the candidate pair connector feature vector;
based on the comparison, designating the candidate pair as a suggested pair; and
indicating the suggested pair in a displayed depiction of the modeled physical structure.

2. The method of claim 1, further comprising the step of:
receiving a user acceptance of the suggested pair.

3. The method of claim 1, further comprising the step of creating a duplicate of the selected supporting element configured to attach to the user accepted suggested pair.

4. The method of claim 1, wherein the supporting element is one of the group consisting of a plate, a gusset, and an end cap.

5. A computer based method for suggesting a structural member based on a selected supporting element for a modeled physical structure in a computer aided drafting (CAD) environment, comprising the steps of:
receiving a selection of the selected supporting element;
designating a first seed structural member attached to the selected supporting element;
creating a feature vector for each of a plurality of candidate structural members in the modeled physical structure;
comparing a first seed structural member feature vector with a structural member feature vector each of the plurality of candidate structural members in the modeled physical structure;
identifying a candidate member of the plurality of candidate structural members as a suggested structural member based on said comparing; and
indicating the suggested structural member in a displayed depiction of the modeled physical structure,
wherein the plurality structural members in the modeled physical structure comprises the first seed structural member, and a feature of the suggested structural member matches a corresponding feature of the first seed structural member.

6. The method of claim 5, further comprising the step of:
receiving a user acceptance of the selected structural member.

7. The method of claim 5, further comprising the step of creating a duplicate of the selected supporting element configured to attach to the selected structural member.

8. The method of claim 5, wherein the supporting element is one of the group consisting of a plate, a gusset, and an end cap.

9. The method of claim 8, further comprising the step of:
designating a second seed structural member attached to the selected supporting element, wherein the plurality of structural members in the modeled physical structure comprises the second seed structural member, and a seed pair comprises the first seed structural member and the second seed structural member;
creating a connector feature vector connecting the first seed structural member and the second seed structural member; and
comparing the connector feature vector with a candidate pair connector vector of the suggested structural member and a candidate paired structural member; and
based on the comparison, designating the suggested structural member and the candidate paired structural member as a suggested pair.

10. A computer program comprising instructions which, when executed by a computer system, cause the computer system to perform the method according to any one of claims 1 to 9.

11. A computer-readable data storage medium having recorded thereon the computer program of claim 10.

12. A computer system comprising a processor coupled to a memory, the memory having recorded thereon the computer program of claim 10.
